# EUROPEAN PATENT APPLICATION

(11) **EP 3 467 892 A1**
(43) Date of publication of application: **10.04.2019**
(21) Application number: 17195284.9
(22) Date of filing: 06.10.2017
(51) Int. Cl.: H01L 51/00

(54) **ANGULAR DEPENDENCE OF LIGHT TRANSMISSION THROUGH OBJECT**

(71) Applicant: Friedrich-Schiller-Universität Jena, 07743 Jena (DE)
(72) Inventor: PRESSELT, Martin, 07743 Jena (DE); HERMANN-WESTENDORF, Felix, 07646 Stadtroda (DE)
(74) Representative: Harrison, Robert John

(57) **Abstract**

An object (10) comprising a substrate (20) and at least one organic film (27) arranged on the substrate (20) is disclosed. The organic film (27) comprises a plurality of amphiphilic molecules (30) arranged on a surface (25) of the substrate (20), and the amphiphilic molecules (30) comprise a chromophore moiety (32) comprising or attached to an anchor group (34) via an optional spacer (36).

## Description

### CROSS-RELATION TO OTHER APPLICATIONS

None

### FIELD OF THE INVENTION

The invention relates to an object comprising a substrate and at least one organic film arranged on the substrate.

### BACKGROUND OF THE INVENTION

A solar cell or a photovoltaic cell is an electrical device that converts energy of light (photons) into electricity by the so-called photovoltaic effect. The operation of a photovoltaic cell requires three basic attributes: The absorption of light in the form of photons, which generate electron-hole pairs in the photovoltaic material, the separation of charge carriers of opposite types in the photovoltaic material and the separate extraction of the charge carriers to an external circuit. A number of materials have been used for photovoltaic cells. For example, crystalline silicon is one of the most commonly used materials and has been researched for a number of years. More recently semiconducting materials such as cadmium telluride, and copper indium gallium selenide have been used.

One example of the use of the solar cells is to coat a substrate, such as window glass, in order to absorb sunlight falling on the window glass. It is desirable that this coating results in a differential absorption of the photons depending on the angle of incidence. It is possible for such a coating to be made from liquid crystal devices, but this requires orientation of electric fields inside the liquid crystal displays in order to achieve this effect and also leads to loss of the photovoltaic function.

Recent organic solar cells (oSCs) have been demonstrated to show a great deal of promise for photovoltaic devices and absorption of photons. These oSCs need to be coated onto a substrate.

Several methods are known to produce one or more layers of the organic photovoltaic material on a substrate. For example, European patent application number 0 203 780 A2 (General Electric Company) teaches a multi-layer organic film having non-linear optical properties, which is laid down on a substrate using Langmuir-Blodgett technologies. Similarly, international patent application number WO 95/04953 A1 (British Technology Group) also shows non-linear optical materials arranged on a substrate using Langmuir-Blodgett technique.

### DESCRIPTION OF THE FIGURES

FIG. 1 shows an example of a window with the organic thin film of the invention.
FIG. 2 shows an example of the organic film of the invention on a substrate.
FIG. 3 shows an example of the chromophore with a spacer and an anchor group.
FIG. 4 shows a Langmuir-Blodgett trough used in the manufacture of the organic thin film of the invention.
FIG. 5 shows the manufacturing method of the invention.
FIG. 6 shows a scheme for the synthesis and structure of the chromophores with three different molecules 1, 5 and 10.
FIG. 7 shows average Π(A)-Isotherm of the thiazole (solid line) with 3 different spacer lengths, molecule 1 (bottom left with square symbols), molecule 5 (middle with circular symbols) and molecule 10 (centre with triangular symbols) recorded at a water phase (filled symbols) and 1% citric acid water phase (open symbols). Dotted line shows non-averaged Π(A)-isotherm of 10 at lower mean molecular areas.
FIG 8 shows compression-expansion hysteresis of a Π(A)-isotherm of 5 (a) and 10 (b,c,d) with 15 compression and expansion cycles.
FIG 9 shows atomic force microscopy (AFM) images of LB-films of 10 at five different deposition pressures; Left-hand figure shows topography images and right-hand figure shows phase images
FIG. 10 shows normalized absorbance and fluorescence emission of LB-films of the molecule 10 at five different ΠLB-pressures (0.5, 6, 8, 12, 14 mN/m) and solution (toluene 1µg/ml).
FIG. 11 shows polarization-dependent fluorescence of LB-films of 5 and 10 at five different ΠLB-pressures (0.5, 6, 8, 12, 14 mN/m) in comparison with a drop-casted sample (10 in a PMMA matrix; grey line). The measurements were performed without analyzer (panel A), excitation at 90° (panel B) and 0° polarization (panel C) and rotation of the analyzer (panels B and C).
Figure 12 shows modelling of the dependence of the experimental fluorescence of LB-films on the polarization angle of the excitation light. I(α) is broadened (A) by convolving I(α) of a uniform chromophore orientation with a Gaussian distribution and (B) by superposition of two distinct phases with shifted individual I(α)-dependencies.
Figure 13 shows polarization-dependent fluorescence of LB-films of 10 at four different surface pressures, 90° and 180° polarization of the excitation light, before (filled symbols) and after annealing (50°C, 15 min.; open symbols)

### DETAILED DESCRIPTION OF THE INVENTION

The invention will now be described on the basis of the drawings. It will be understood that the embodiments and aspects of the invention described herein are only examples and do not limit the protective scope of the claims in any way. The invention is defined by the claims and their equivalents. It will be understood that features of one aspect or embodiment of the invention can be combined with a feature of a different aspect or aspects and/or embodiments of the invention.

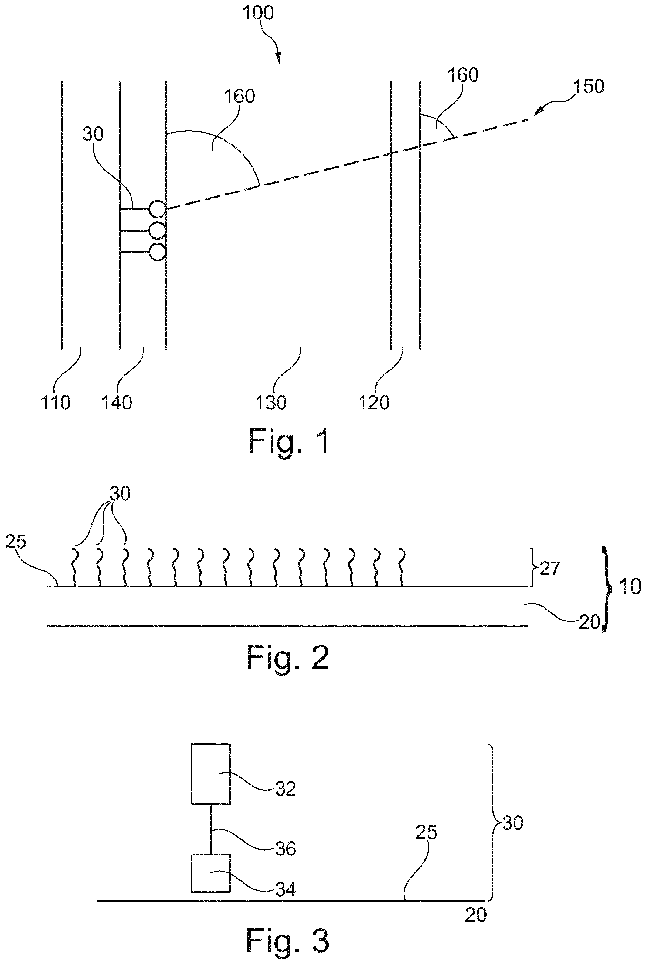

FIG. 1 shows an example of an object, such as a window 100, which comprises a first window pane 110 and a second window pane 120. The first window pane 110 and the second window pane 120 can be made of a window glass or a polymer. There is a space 130 arranged between the first window pane 110 and the second window pane 120, which serves as a thermal barrier. An organic film 140 is arranged on the inner surface of the first window plane within the space 130. The organic film consists of a plurality of amphiphilic molecules 30 arranged in a plurality of layers. The structure of these amphiphilic molecules 30 will be described below. Light 150, such as sunlight or from an artificial light, impacts on the second window pane 120 and is absorbed at least partially by the organic molecules in the organic thin film 140 arranged on the inner side of the first window pane 110. It is found that the degree of absorption of the photons in the light 150 is dependent on the angle of orientation 160 of the light 150 impinging on the amphiphilic molecules 30 in the organic film 160.

It will be appreciated that the window 100 shown in FIG. 1 is only one example of the use of the organic molecules 140, as described in this disclosure. The organic molecules 140 can be applied to other substrates of objects having a substantially smooth surface, such as a quartz-based glass, or a transparent polymer such as, but not limited to, polyethylene terephthalate (PET), polyethylene naphthalate (PEN), polyvinyl chloride (PVC), cellulose di- and triacetate (CTA), and polyester, including polycarbonate.

Other uses of the organic molecules 140 on substrates include, but are not limited to solar cells and laptop covers.

FIG. 2 shows an example of an object 10 having one layer 27 of the amphiphilic molecules 30 in the organic film 140 arranged on the first window pane 110. FIG. 2 shows in particular that the organic film 140 of FIG. 1 is arranged as a plurality of amphiphilic molecules 30 on the surface 25 of a substrate 20 to form a single layer 27 of the organic film 140. Further layers of the amphiphilic molecules 30 are arranged, if required, on this single layer. It is possible to produce up to 100 layers of the amphiphilic molecules 30.

FIG. 3 shows the structure of the amphiphilic molecules 30. The amphiphilic molecules 30 have a chromophore moiety 32 attached to an optional spacer 36 which is attached to an anchor group 34. The anchor group 34 is for example a polar moiety, which anchors the amphiphilic molecule 30 to the surface 25 of the substrate 20. In one aspect, the anchor group could be a polar group which is part of the chromophore moiety 32.

In three non-limiting examples, the chromophore moiety 32 is a thiazole, a merocyanine, or a BODIPY dyad (boron-dipyrromethene). Examples of merocyanine include, but are not limited to, 1,1'-Diethyl-2,2-carbocyanine iodide (also called pinacyanol iodide or quinaldine blue) and 3,3'-Diethylthiacyanine iodide. Both of these have a polar group which is part of the chromophore moiety 32.

In general, the chromophore moiety 32 should have a transition in the visible region and the electron transition dipole should have the same orientation as the amphiphilic molecule 30. In a non-limiting example, the anchor group 34 is a carboxylic acid head. Other examples of the anchor group 34 include, but are not limited to, carboxylic acid, sulfonic acids, sulphonamides, amides, phosphonic acids, alcohols, and thiols. In a non-limiting example, the spacer 36 is alcylic.

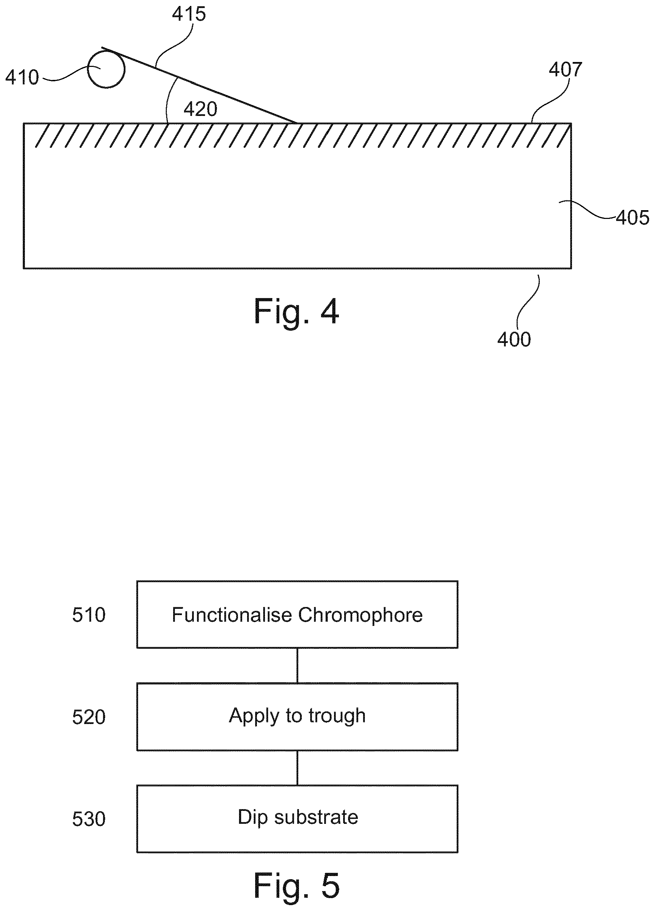

The method of manufacture of the organic film 27 on the surface 25 of the substrate 20 will now be described with respect to FIGs. 4 and 5. In a first step 510 a chromophore is functionalized to produce an amphiphilic chromophore having the chromophore moiety attached to the anchor group 34, in one aspect via the optional spacer 36. A liquid comprising the functionalized chromophores is applied in step 520 to the surface of a Langmuir-Blodgett trough 400 as shown in FIG. 4.

The Langmuir-Blodgett trough 400 comprises a liquid 405 having a surface on which the organic film 407 is located. It will be appreciated that the organic film 407 is immiscible with the liquid 405. The liquid 405 is often water. In prior-art Langmuir-Blodgett troughs a substrate 415 is generally oriented in a vertical direction (z-direction) into the Langmuir-Blodgett trough 400 and dipped into the liquid 405 through the organic film 407. The layer of organic film 407 is attached through the anchor groups to the surface of the substrate 415 as the substrate 415 is pulled out of the Langmuir-Blodgett trough 405.

In the example shown in FIG. 4, the substrate 415 is pulled out in step 520 of the Langmuir-Blodgett trough 400 at an acute angle 420, as can be seen in the FIG. 4. The reason for this change in the angle of dipping from an orthogonal (z) direction is due an analysis of the deposition procedure of the thin organic film 407 on the substrate 415. It has been discovered that pulling at a non-orthogonal angle of, for example between 10° and 30° can yield more stable film on the substrate 415. A roller 410 is used to pull the substrate 415 through the Langmuir-Blodgett trough 400. In another aspect, a horizontal "stamping" technique may be used to place the thin organic film 407 on the substrate.

It will be appreciated that the substrate can be a continuous substrate and that the Langmuir-Blodgett trough shown in FIG. 4 could be in the form of a roll-to-roll system. It will be also appreciated that the substrate 415 could be used to form the thin organic film 407, which can then be later transferred to another substrate.

### Examples

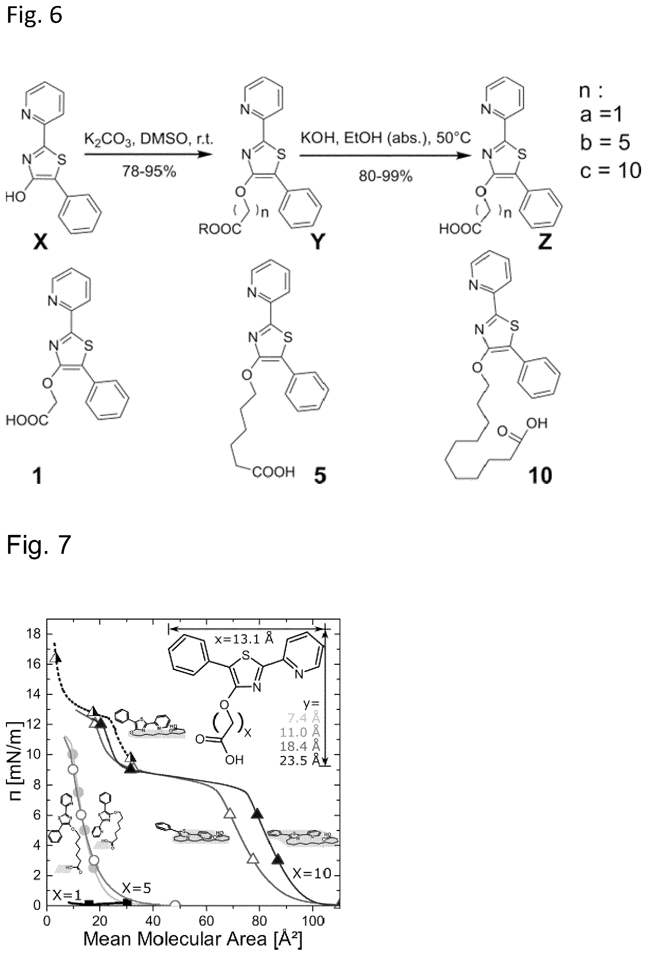

FIG. 6 shows a scheme for the synthesis and the structure of the chromophores. The starting 4-hydroxy-1,3-thiazole X was obtained via Hantzsch cyclisation reaction from 2-pyridinecarbothioamide with ethyl α-bromo-phenylacetate with pyridine as base, as described by Täuscher, E.; Weiß, D.; Beckert, R.; Görls, H. Synthesis 2010, 2010, 1603. The hydroxyl group was alkylated with a ω-bromoalkanoic ester to both increase the solubility and install the amphiphilic precursor with different spacer lengths, as shown in FIG. 6. First attempts of Williamson type etherification with potassium carbonate in acetone lead to good yields for the methyl acetate derivative58, but only poor to moderate yields are obtained for longer halogenalkanes. Therefore, the reaction conditions were changed to potassium carbonate in dimethyl sulfoxide at room temperature whereby all ethers could be isolated in good to excellent yields (see: Gampe, D. M.; Nöller, F.; Hänsch, V. G.; Schramm, S.; Darsen, A.; Habenicht, S. H.; Ehrhardt, S.; Weiß, D.; Görls, H.; Beckert, R. Tetrahedron 2016, 72, 3232). The last reaction step is the saponification of the ester groups. The standard procedure in ethanol with aqueous potassium hydroxide solution at room temperature (Habenicht, S. H.; Schramm, S.; Fischer, S.; Sachse, T.; Herrmann-Westendorf, F.; Bellmann, A.; Dietzek, B.; Presselt, M.; Weiß, D.; Beckert, R.; Görls, H. Journal of Materials Chemistry C 2016, 4, 958) works well for the methyl acetate derivative, while with the hexanoic ester and the undecanoic ester no conversions were observed. Different approaches with variation of temperature and base did not improve the yields. Finally, the conversions with dried potassium hydroxide in absolute ethanol and exclusion of moisture gave the desired products 1, 5 and 10 in very good yields (80-99%).

The chromophores have a good solubility in a broad range of solvents because of the amphiphilic character. Molecule 1 of FIG. 6 shows the best solubility for protic polar solvents like water and even nonpolar solvents like toluene. In contrast, molecules 5 and 10 are only water soluble in alkaline or strong acidic solutions due to the deprotonation of the carboxylic group or the protonation of the pyridine moiety, respectively, with the highest solubility in chloroform and THF.

The surface pressure (Π) - vs. mean molecular area (A) - isotherms of the 4-hydroxy-1,3-thiazole are shown in FIG. 7. The Π(A)-isotherm of the molecule 1 is flat even at small areas per molecule. Hence, the molecule 1 is not sufficiently amphiphilic to form stable Langmuir monolayers on the LB-trough but rather dissolves in the water-subphase.

For the molecule 5, the isotherm shows a steep rise after the liquid phase (20-40 Å²) that indicates a solid phase with an extrapolated minimum molecular area (AO) of 18.0 Å² (FIG. 7). In case of monomolecular Langmuir films with uniform molecular orientations, the latter can be deduced from the molecular packing density in the Langmuir layer, or the A0-areas that are inversely proportional to the packing density. Therefore, for different molecular orientations the theoretical geometric molecular area requirements on the subphase surface are compared with the measured A0-areas. The molecular orientations are then identified by the best fit between the theoretical areas and the single experimental A0-area. In case of the molecule 5 a small area of 19.2 Å² is obtained, when multiplying the molecular y-length of 5 (7.4 Å, see F**Fehler! Verweisquelle konnte nicht gefunden werden.**IG. 7) with the sulfur van der Waals diameter (2.6 Å). Because this area approximately fits the determined A0-area of 18.0 Å², it was concluded that the chromophore in the organic thin film 27 is vertically oriented on the water surface 25 in the solid phase. At a surface pressure of Π = 10.5 mN/m the isotherm shows a characteristic bend that could be due to a supramolecular phase change of the solid phase. The influence of subphase acidity (1% citric acid in subphase: pH = 2.4) on the isotherm is weak, as shown in FIG. 7 (default (deionized ultra-pure water): pH = 6). Therefore, for both subphases we deduce orientations of the molecule 5 with the pyridine, which would change the Π(A)-isotherm if it could be pulled into the subphase by increasing acidity, distant from the subphase, i.e. the left-hand side structure in FIG.7 with large pyridine-subphase distance.

The molecule 10, with the longest spacer, shows multiple phases. The isotherm starts rising at larger molecular areas (FIG 7) as compared to 5, leading to a first solid phase I between 75 and 100 Å² and a characteristic A0,I-value of 94.0 Å². If we divide A0,I by the long molecular axis (x shown in the inset of Fig. 7 having a length (13.1 Å) the resulting width is 7.2 Å, which is similar to the y-length determined for the same chromophore in the molecule 5. Therefore, we conclude that the molecule 10 is oriented horizontally at the water surface 25 in the first solid phase. The flexible alkyl chains are expected to fit the interstitial spaces. Increasing the acidity of the subphase lowers A0,I significantly to 85.4 Å². This decrease is attributed to a tilted orientation of the chromophore on the water surface 25 due to enhanced interactions between the pyridine moiety and the water subphase. This tilt of the chromophore allows for partial overlapping of the chromophores, yielding a denser packing and the lowered A0,I-value.

After reaching a surface pressure of Π ≈ 7.5 mN/m the isotherm of the molecule 10 shows a phase transition at which the monolayer is easily compressible as indicated by the small slope of the Π(A)-isotherm. This transition phase is compressible because local molecular reorientations release lateral stress from the densely packed phase I Langmuir layer. At 35 Å² a second solid phase starts to form (default pH = 6 subphase) and features an A0,II-area of 42.8 Å². This area is a little larger than what we would expect from turning the molecule 10 around its long axis to a vertical orientation on the water surface (34.0 Å² as deduced from the sulphur van der Waals diameter (2.6 Å) and the molecular x-length (13.1 Å)) if just the chromophore geometry is considered. The difference between these areas is assigned to the alkyl spacer. Due to the tilt of the chromophore the interaction with the subphase changes from facial, including the polarizable π-system and all hetero-atoms, to binding just via two heteroatoms as shown in FIG. 7. This binding might be enhanced by decreasing the pH-value, but that apparently does not influence the isotherm and presumable not the supra-molecular geometry significantly in the second solid phase as shown in FIG. 7. The supra-molecular structure in this densely packed second solid phase is additionally influenced by ππ-interactions between the chromophores.

At Π = 12.5 mN/m a second phase transition starts, but the experimental setup limits the minimal molecular area per run. Therefore, a second Π(A)-isotherm was measured with a starting point at the onset of the second solid phase (dashed line in FIG. 7), i.e. higher thiazoles concentrations are used in the solution spread onto the subphase surface. At the resulting increased surface concentration assembly into the two-dimensional structures of the second solid phase described before might be hindered and locally different supra-molecular assemblies such as micelles might be formed. However, this second isotherm is just slightly shifted to larger mean molecular areas in the second solid phase as compared to the first isotherm staring at low surface concentrations. This second isotherm shows that after the second transition phase a third solid phase with even denser packing is formed, which is characterized by an A0,III-area of 12.1 Å².

This A0,III-area of the molecule 10 is even smaller than the value determined for the first solid phase of 5 (18.0 Å²). Nevertheless, we assign a vertical chromophore orientation to the third solid phase of the molecule 10 according to the discussion of the molecule 5. The difference between the A0-values of the molecule 5 and the molecule 10 at similar molecular orientations is inherently linked to the spacer length. While it is expected that a regular packing for the molecule 5, the spacer in the molecule 10 exceeds the chromophore lengths what probably causes interstitial gaps. If these gaps are filled with horizontally oriented thiazoles the effective packing density for the molecule 10 is higher than in case of the molecule 5, thus explaining the difference in the A0-values. Consequently, for maximum molecular order, the spacers should not be too long, to avoid formation of interstitial gaps. In summary, it is found that the spacer length has a dramatic influence on the supra-molecular structures that are accessible in Langmuir films.

The supra-molecular structures differ in their molecular orientation, their interaction with the subphase and in their inter-molecular interactions. The latter were studied in more detail by means of hysteresis experiments and are discussed in the next section.

Table 1 shows the extrapolated minimum molecular area A0 of the different phases of the thiazole with a spacer length of 5 and 10 at a water- and 1% citric acid-phase (CA). Shaded cells represent A0-areas extrapolated from Π(A)-isotherms with a starting point at the onset of the second solid phase

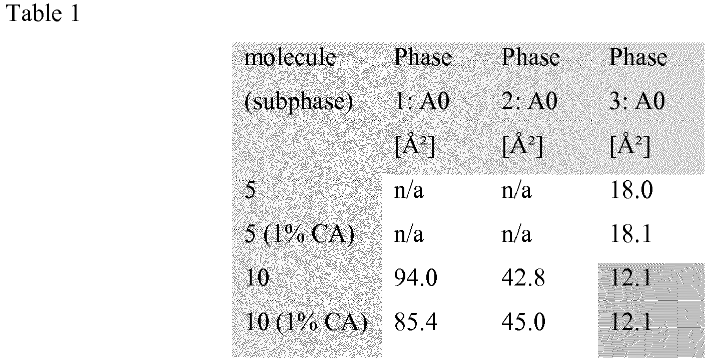

### Hysteresis

The intermolecular interactions between the amphiphiles in the individual solid-state phases are probed by compression to target surface pressures that are characteristic for the individual phases. Subsequent expansion of the film and further compression-expansion (CE) cycles will cause hysteresis of the Π(A)-isotherm if thermodynamically stable aggregates are formed in the probed phase. In this case their binding energy is larger than the thermal energy at the given experimental conditions (25.18 - 25.44 meV). The energy that is stored in a Langmuir layer at a compression can be directly determined from the area between two subsequently determined Π(A)-isotherms.

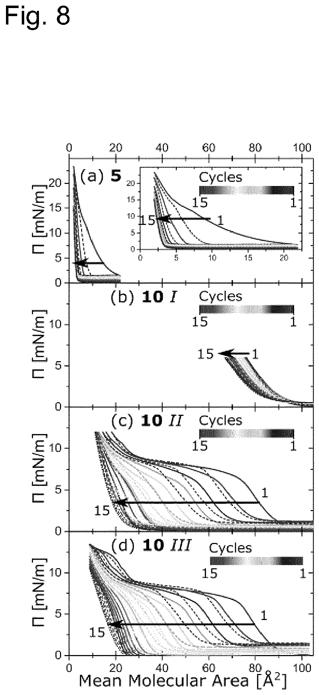

In case of the molecule 5 the A0-areas strongly decrease from 18.1 Å² to 4 Å² with the first two CE-cycles and converges at approximately 3 Å² for more CE-cycles as shown in FIG. 8. These tiny areas - in particular compared to the molecular dimensions - cannot be assigned to single molecules in a two-dimensional packing pattern, but rather indicate facile formation of three-dimensional aggregates, such as micelles. Thus, since no stable 2D-layers can be obtained from 5, it is not further considered in detail in what follows.

In case of the molecule 10 no stable aggregates are expected to form in the first solid phase since just edge to edge interactions between the molecules shall be possible. Nevertheless, a small decrease of the A0-values (from 95 to 85 Å² at 15 CE-cycles) can be found at subsequent CE-cycles as shown in FIG 8B, while the change between Π(A)-isotherms within a single CE-cycle is negligible.

In stark contrast, when probing the second solid phase (Πtarget=12 mN/m) the A0,II-areas significantly decrease within each CE-cycle (see FIG. 8), thus indicating the formation of aggregates that are stable at room temperature. These aggregates are bound by π-π interactions between the chromophores. The necessary face-to-face chromophore orientations are enabled by the tilts around the molecular edges when forming phase II, as derived above from the A0-areas In phase II of 10 we consider the aggregation energy to equal a dimerization energy. Since the phase I-characteristics have virtually vanished from the Π(A)-isotherm after 15 CE-cycles, the dimerization energy was determined by calculating the difference between the first compression and the last compression, last expansion, respectively, thus yielding ΔGII=30-32 meV. Note that the A0,II-areas of the second phase shift with repeated CE-cycles to areas lower than the one determined in the previous section (see Table 1, possibly due to improved packing upon repeated CE-cycles.

When targeting phase III of the molecule 10 the evolution of the Π(A)-isotherms with the CE-cycles is very similar to the one when targeting the second solid phase, as shown in FIG. 8. The deduced dimerization energy (ΔGIII=31.25 meV) does virtually not differ from the one in phase II as π-π interactions constantly dominate the intermolecular interactions with altered molecular orientation. Thus, while the short spacer in the molecule 5 does not allow for the formation of thermodynamically stable 2D-Langmuir layers, the longer spacer in the molecule 10 enables stable 2D-Langmuir layers for the second and third solid phase. However, the determined intermolecular binding energies for the molecule 10 are just slightly above the thermal energy at room temperature.

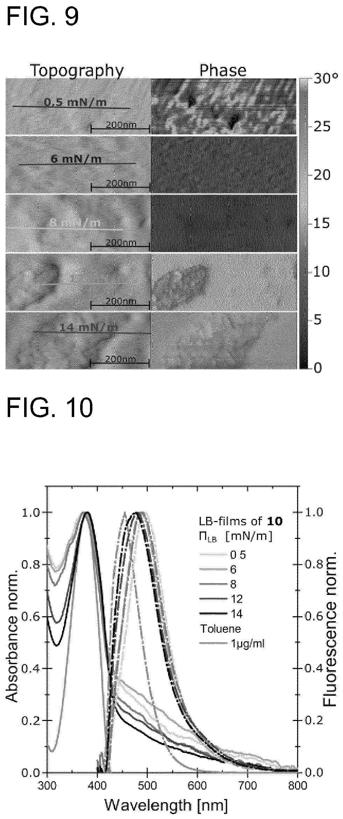

For morphological characterization by means of atomic force microscopy (AFM) Langmuir-layers of Compression-expansion hysteresis of a Π(A)-isotherm of 5 (a) and 10 (b,c,d) with 15 compression and expansion cycles 10 were deposited onto quartz glass substrates. These Langmuir-Blodgett (LB) layers show a smooth topography when deposited at surface pressures ΠLB within or below the first solid phase as shown in FIG. 9. The corresponding phase images, which are sensitive to the chemical interaction between the molecules in the layer and the AFM-tip, show a random orientation of small aggregates for the liquid phase (deposition pressure ΠLB=0.5 mN/m) that becomes more uniform with higher surface pressure at deposition (ΠLB: 6, 8 mN/m), i.e. increasing supra-molecular order in phase I.

When increasing ΠLB to 12 mN/m (phase II), the AFM-phase image shows the co-existence of two individual solid phases. The boarder between them can also be seen in the topography image. We assign these phases to phases I and II as identified from the Π(A)-isotherms. A similar pattern is found for ΠLB = 14 mN/m. Since at ΠLB = 14 mN/m the Langmuir-layer is at the edge between the second transition phase and the third solid phase, we might tentatively assign the two phases in the AFM-images at ΠLB = 14 mN/m to phases II and III of 10. However, due to the phase co-existence and the limited scanned area in AFM an unambiguous assignment of the different phases is not possible in the framework of the here reported research, expect for phase I of Compression-expansion hysteresis of a Π(A)-isotherm of 5 (a) and 10 (b,c,d) with 15 compression and expansion cycles the molecule 10, as discussed above.

### Absorption and Fluorescence Spectra of Solutions and LB-Films

To identify the influence of the molecular order, which can be varied between different solid phases just in case of the molecule 10, on optical properties of 10 UV-vis absorption and fluorescence spectra of LB-films deposited at different surface pressures were measured and compared to spectra of the molecule 10 dissolved in toluene. The absorption spectra essentially feature single absorption peaks with maxima at -375 nm, as shown in FIG. 10, which can be assigned to the S0→S1 transition. This maximum slightly shifts to higher wavelengths with increasing molecular order at higher deposition pressure ΠLB (372 nm at 0.5 mN/m to 379 nm at 14 mN/m). Accordingly, the fluorescence maxima shift from 495 to 476 nm with increasing molecular order with slight changes of the spectral shape. This change is assigned to alterations in the vibrational progression with raising intensity of the 0-0 transition upon denser packing with increasing deposition pressures, cf. changed vibrational progression with varied morphologies of small molecule chromophores63-67 and polymers68-70. However, the fluorescence maximum of the toluene solution is at even shorter wavelengths (455 nm).

### Polarization-Dependent Fluorescence of LB-Layers

Finally, the thermodynamic stabilities of deposited individual phases of 5 and 10, i.e. Langmuir-Blodgett rather that the Langmuir layers characterized by hysteresis experiments above, are evaluated by analysis of possible changes of their molecular orientation upon thermal annealing. Therefore, the molecular orientation of LB-films that were deposited on quartz-glass is investigated by means of polarization-dependent fluorescence spectroscopy.

In the polarization-dependent fluorescence measurements the LB-film is irradiated in grazing incidence (20° to the substrate normal vector) and the emitted light is collected in a back-scattering geometry 5° to the substrate normal. In case of upright standing molecules (transition dipole vector, TDV, parallel to the substrate normal) maximum absorption, and therefore maximum emission I(α) would be obtained at α = 0° polarization and no absorption and emission would be detected at α = 90°. Consequently, a periodic change of the fluorescence intensity I(α) will be obtained for systematic tuning of the polarization angle α of the incident light if the TDVs are oriented uniformly.

### Isotropic Molecule Orientations

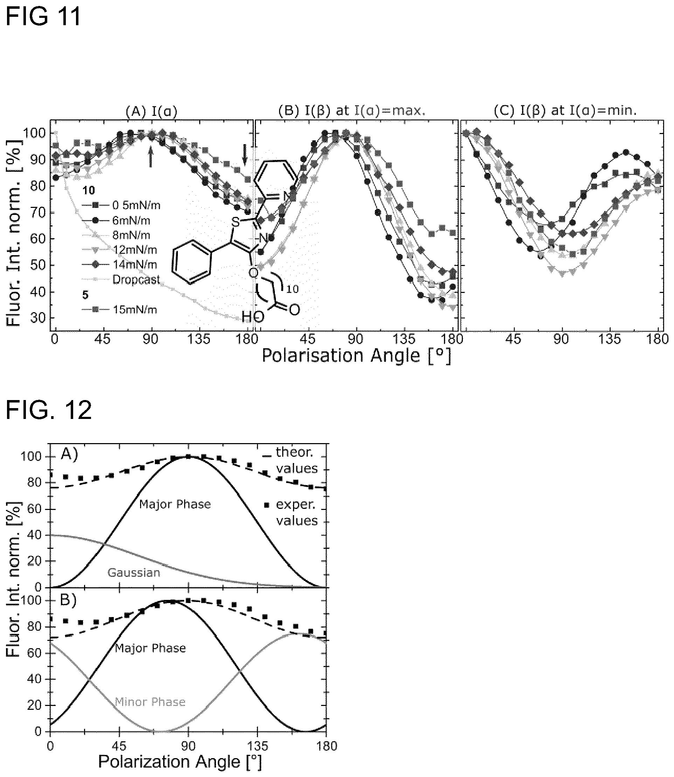

In contrast to uniformly oriented chromophores, no periodic I(α) relation is obtained for isotropically oriented chromophores, as in the case of chromophores embedded in an isotropic matrix, like drop-cast poly(methyl methacrylate) (PMMA) represented by the grey (bottommost) line in FIG 11A. Particularly, I(α) of the molecule 10 in PMMA monotonically decreases with larger polarization angles of the incident light as shown in FIG. 11A. We attribute this decrease in the fluorescence intensity to static quenching upon reorientation of the chromophores during fluorescence detection. This reorientation from random molecule orientations after drop-casting to energetically more favourable supra-molecular geometries is supposed to be driven by thermalized absorbed energy, i.e. by photo-annealing. The quenching might be due to self-quenching or unfavourable rotation of the TDVs.

In case of the molecule 5 non-uniform chromophore orientation is expected if the Langmuir layer is deposited at ΠLB=15 mN/m as discussed above in the hysteresis section. However, in contrast to the drop-cast PMMA film discussed before, the fluorescence is not monotonically decreasing but rather slightly varies between 100 and 90% normalized fluorescence intensity (α<90°). At ∼90° polarization of the incident light the fluorescence is most intense and decreases to 83% at 180°, as shown in FIG 11A.

The fact that the fluorescence quenching upon photo-annealing is significantly weaker than in case of the PMMA drop-cast film is attributed to the energetically favourable LB-assembly of the molecule 5. Furthermore, the above discussed formation of stable 3D-aggregates, such as micelles, in the Langmuir layer of the molecule 5 would result in isotropic chromophore orientation and constant I(α), if photo-annealing could be neglected. The fact that I(α) passes a maximum at 90° indicates a slight preferred chromophore orientation in the direction the substrate was pulled out of the LB-trough.

In case of the molecule 10 I(α) of all LB-films show pronounced maxima I(α)max between 75 and 95° polarization and slight photo-annealing. Notably, the difference between I(α)max and I(α)min, i.e. the fluorescence contrast ΔI = I(α)max - I(α)min, is virtually independent on ΠLB, instead of increasing for more ordered films as expected for increasing ΠLB. For perfectly uniform chromophore orientations we would expect ΔI=100% as discussed above, but instead detect ΔI-values between 25 and 30% for all LB-films of 10. Possible reasons for this low fluorescence contrast are convolution of the sinoidal I(α)-dependence with a Gaussian distribution of chromophore orientations, as shown in FIG. 12A, or superposition of two distinct phases with different chromophore orientation and distinct, phase-shifted sinoidal I(α)-dependencies, as shown in FIG. 12B, or a combination of both.

Considering the individual phases of the molecule 10, we find that I(α)max is constant at 75° polarization when increasing ΠLB from pressures corresponding to the liquid till those of the first solid phase (0.5, 6 mN/m). When targeting the first transition and solid phases II and III (8, 12, 14 mN/m) I(α)max shifts to α=95°. This shift again might be explained by two different models: Either the more densely packed films at ΠLB>6 mN/m, i.e. beyond solid phase I, involve chromophores that are not parallel to the substrate surface but slightly rotated towards the substrate normal or the ratio between two solid phases with phase shifted I(α)-dependencies changes. The latter model is in full accordance with the AFM-derived coexistence of at least two phases after deposition beyond ΠLB-values characteristic for phase I.

In case of two distinct phases, upon fixing the polarizer in the position of maximum, minimum fluorescence at 90°, 0° predominantly the phase with the larger, smaller weight is probed, respectively, see FIG. 11. For both cases, the polarization of the light emitted by the LB-layers is measured by means of an analyzer. Probing of the major phase (I(β,α=90°)) essentially yields maxima between 70° - 80° and significantly enhanced fluorescence contrasts between ΔI=55 and 65% as shown in FIG. 11B. Thus, the predominant chromophore orientation is close to 90°, i.e. chromophores are laying rather flat on the substrate surface. The coincidence between dominant chromophore orientation at α≈90° and the LB-deposition direction for basically all investigated LB-films indicates a distinct influence of the deposition on the chromophore orientation. However, the fluorescence contrast AI(β) is still rather independent from ΠLB, thus indicating that the molecular order in the major phase is already high at low ΠLB, presumably due to self-assembly, and cannot be increased significantly by increasing ΠLB in the major solid phase.

As shown in FIG. 12, probing the minor phase (I(β,α=0°)) yields increased fluorescence contrasts as well and maxima at 0 and 180° for ΠLB>6 mN/m. In case of phase I (ΠLB=0.5, 6 mN/m) the maximum and minimum is shifted to lower polarization angles by ∼23° as compared to I(β) of the other phases. Furthermore, and in contrast to I(α), the fluorescence contrast ΔI(β) in the minor phase systematically increases with larger ΠLB-values, except for ΠLB=14 mN/m where the 2D-layers might be already disrupted, cf. the molecule 5.

After having identified that deposition of phase III of 10 (ΠLB=14 mN/m) involves perturbation of the 2D-layer the thermodynamic stability of the individual phases of the molecule 10 is tested by means of thermal annealing to yield thermodynamic characteristics of deposited LB-layers, cf. thermodynamic characterization of non-deposited Langmuir layers by means of hysteresis experiments above. Therefore, I(β) at fixed α (90°, 180°) were compared before and after short thermal annealing (50°C, 15 min.). Variations in I(β) upon thermal annealing would indicate reorganization to thermodynamically more favourable supra-molecular structures.

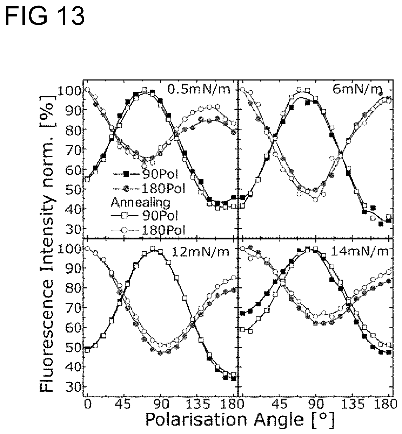

As shown in FIG 13, rather small changes of I(β) upon thermal annealing can be observed for any of the investigated LB-films, except slightly weakening the photo-annealing discussed above. For the liquid phase (ΠLB=0.5 mN/m, AI(β)major=60%, ΔI(β)minor<35%) thermal annealing reduces photo-annealing just in the minor phase, while for the even less ordered disturbed phase III LB-film (ΠLB=14 mN/m, ΔI(P)major=50%, ΔI(β)minor<35%) thermal annealing reduced photo-annealing in both the major and minor phase. For the relatively highly ordered phase II LB-film (ΠLB=12 mN/m, Al(P)major=65%, Al(P)minor<50%), where we deduced co-existence with a second phase (presumably phase I), thermal annealing influences just the minor phase. The latter shows already a high degree of molecular ordering as deduced from the large Δl(P)minor fluorescence contrast above. With respect to the given annealing parameters the most stable LB-film is the one deposited at ΠLB=6 mN/m (phase I, ΔI(β)major=65%, ΔI(P)minor<55%), where photo-annealing is almost negligible and I(β) is basically not changed upon thermal annealing. In phase I the molecular orientation in the Langmuir- and the LB-film coincide with thermodynamically favourable molecular orientations for interactions with the substrate, thus yielding stable layers after deposition onto quartz-glass.

### Experimental details

### Langmuir-Blodgett (LB) Films

Solutions of the dyes (1 mg/ml in CHCl3) were carefully spread onto the subphase (ultra-pure water) of the LB-trough (KSV NIMA Alternate L 105 and LB Trough). For complete evaporation of CHCl3 a time of 10 min were waited before moving the barriers. Then, the barriers were compressed with 5 mm/min to record the isotherms. The compression and expansion were performed with the same speed and without dwell time at the reversal points. Quartz glass substrates were treated with acetone and iso-propanol in the ultrasonic bath for each solvent 3 times and the substrates were stored in isopropanol. The deposition of LB-films on the quartz-glass (30 mm x 5 mm x 1mm) was done using Z-type dipping with constant pressure and a dipping speed of 5 mm min-1

### Atomic Force Microscopy (AFM)

AFM was carried out using a Veeco Digital Instruments Dimension 3100 AFM in tapping mode with a silicon tip (radius < 8 nm) at 300 kHz with a force constant of E40 N m-1 (Budget Sensors Tap 300-G)

### UV-vis Absorption and Fluorescence Spectroscopy

The absorption spectroscopic measurements we used a UV-vis (Varian: Cary 5000) spectrometer in transmission mode. The fluorescence measurements were made on a costume built setup. This consists of an Isoplane 320 Spectrograph with a cooled Pixis CCD-Camera from Princeton Instruments. A fibre coupled 5 mW laser with a 405 nm output wavelength was used as excitation source (incident under 55°) and the emission were detected under 35° to the normal. Long pass filters with low self fluorescence from ITOS were used to block scattered excitation light. For the polarized fluorescence measurements, a polarizer was placed in front of the excitation and an analyzer in front of the spectrometer. Here, the sample was excited under an angle of 20° and the emission was detected under an angle of 5° with respect to the substrate normal. A notch filter (Thorlabs NF405-13) was placed in front of the spectrograph to block scattered excitation light and a better filter correction for low signals. The polarizers were rotated in 10° steps. The data were corrected by a self-written LabView and C++ program. These programs remove last scattered excitation light and cosmic rays. The maxima of the fluorescence spectra were analysed by a self-written Mathematica program.

### Reference Numerals

- 10: Object
- 20: Substrate
- 25: Surface
- 27: Layer
- 30: Amphiphilic Molecules
- 32: Chromophore moiety
- 34: Anchor Group
- 36: Spacer

- 100: Window
- 110: First window pane
- 120: Second window pane
- 130: Space
- 140: Organic film
- 150: Light
- 160: Angle of orientation

- 400: Langmuir-Blodgett trough
- 407: Thin organic film
- 410: Roller
- 415: Substrate
- 420: Acute angle

## Claims

1. An object (10) comprising
a substrate (20); and
at least one organic film (27) arranged on the substrate (20), wherein the organic film (27) comprises a plurality of amphiphilic molecules (30) arranged on a surface (25) of the substrate (20), and wherein the amphiphilic molecules (30) comprise a chromophore moiety (32) attached to an anchor group (34), wherein the transmission of light through the at least one organic film (27) is dependent on the angle of transmission of the light.

2. The object of claim 1, wherein the anchor group (34) is separated from the chromophore moiety (32) by a spacer (36).

3. The object of claim 1, wherein the anchor group (34) is a polar group forming part of the chromophore moiety (32).

4. The object (10) of any of the above claims, wherein the substrate (20) is one of a glass substrate or a polymer film.

5. The object (10) of any of the above claims, wherein the chromophore moiety (32) is one of a thiazole, a merocyanine, or a BODIPY dyad (boron-dipyrromethene).

6. The object (10) of any of the above claims, wherein the anchor group (34) is a polar moiety.

7. The object (10) of claim 6, wherein the polar moiety is selected from the group consisting of carboxylic acid, sulfonic acids, sulphonamides, amides, phosphonic acids, alcohols, a pyridinium salt, an ammonium salt, or thiols.

8. The object (10) of any of the claims 2 or 3 to 7, wherein the spacer (36) is alkylic, π-conjugated, or aromatic.

9. A method for the manufacture of an object comprising:
- functionalisation of a chromophore to produce an amphiphilic chromophore having a chromophore moiety (32) comprising or attached to an anchor group (34);
- applying the amphiphilic chromophore to a surface (25) of a substrate (20).

10. The method of claim 9, wherein the applying of the amphiphilic chromophore (30) comprises forming a layer of the amphiphilic chromophore on the surface of a liquid phase and dipping the substrate (20) at a non-orthogonal angle through the layer of the amphiphilic chromophore (30).

11. Use of the object (10) of any one of claims 1 to 8 as a window (100).
